# EUROPEAN PATENT SPECIFICATION

(11) **EP 4 447 629 B1**
(45) Date of publication and mention of the grant of the patent: **18.11.2026**
(21) Application number: 23829392.2
(22) Date of filing: 13.02.2023
(51) Int. Cl.: F28D 15/04, F28D 15/02, H10W 40/73

(54) **VAPOR CHAMBER, HEAT SINK AND ELECTRONIC DEVICE**
DAMPFKAMMER, KÜHLKÖRPER UND ELEKTRONISCHE VORRICHTUNG
CHAMBRE À VAPEUR, DISSIPATEUR THERMIQUE ET DISPOSITIF ÉLECTRONIQUE

(30) Priority: 29.06.2022 CN 202210750928
(43) Date of publication of application: 16.10.2024
(73) Proprietor: ZTE Corporation, Shenzhen, Guangdong 518057 (CN)
(72) Inventor: SUN, Zhen, Shenzhen, Guangdong 518057 (CN); CHEN, Xiaoxue, Shenzhen, Guangdong 518057 (CN); DUAN, Zhiwei, Shenzhen, Guangdong 518057 (CN); XU, Qingsong, Shenzhen, Guangdong 518057 (CN)
(74) Representative: Osterhoff, Utz
(86) International application number: PCT/CN2023/075573
(87) International publication number: WO 2024/001199

(56) References cited:
- CN-A- 108 801 015
- CN-A- 111 863 746
- CN-A- 114 251 964
- CN-U- 212 013 418
- CN-U- 214 381 989
- CN-U- 214 381 989
- CN-U- 214 582 689
- US-A1- 2013 025 829
- US-A1- 2022 046 783

## Description

### TECHNICAL FIELD

The present application relates to the technical field of heat dissipation for electronic devices, and in particular, to a vapor chamber, a radiator and an electronic device.

### BACKGROUND

At present, IC chips are the core of computing in electronic devices and one of the main heating components of electronic devices. With the development of 5G communication technology, communication products are pursuing large capacity and high performance. In particular, some multi-functional IC chips are becoming more and more integrated, causing the power consumption and heat flow density of IC chips to continue to rise, posing severe challenges to heat dissipation technology.

At present, liquid cooling technology is not yet mature, and chip heat dissipation problems mainly rely on air-cooling heat dissipation technology to solve, and vapor chamber heat dissipation technology is the key technology for air-cooling heat dissipation. A vapor chamber (VC) mainly includes a shell, a capillary structure and a working medium (also called fluid medium). The VC forms a closed cavity. The inside of the cavity is evacuated and filled with the working medium, which causes the working medium to undergo phase change and transfer heat.

CN214381989U provides a gas-liquid separation heat dissipation device, including an upper cover, a lower cover, a support, a heat transfer structure, a plurality of different capillary structures and a metal foil, wherein the metal foil is attached to the transmission zone, and is used to separate the gas formed in the evaporation zone from the condensed liquid refluxed from the transmission zone.

In US20130025829A1, a vapor chamber is configured to conduct heat generated by a heat-generating element and includes a bottom plate, a first wick structure, a second wick structure, a cover plate and a working fluid filled between the cover plate and the bottom plate. One side of the bottom plate has a heated protrusion in thermal contact with the heat-generating element, and the other side is formed with an accommodating trough corresponding to the heated protrusion. The first wick structure is provided in the accommodating trough. The second wick structure is disposed on the bottom plate and provided with an opening and a plurality of airflow channels in communication with the opening. The cover plate tightly covers the bottom plate. The supporting posts are sandwiched between the cover plate and the first wick structure. By this arrangement, the mounting and heat-conducting of the heat-generating element can be achieved.

CN111863746A provides a heat dissipation device, a circuit board and an electronic device. The heat dissipation device includes a heat-conducting housing. When connected to a chip, the chip is located in the chip placement area of the heat-conducting housing. The heat-conducting housing is provided with a capillary structure, and a working medium is filled in the capillary structure. To improve the heat dissipation effect of the chip, the capillary structure includes a first capillary structure and a second capillary structure that are connected, and the maximum thickness of the first capillary structure is less than the minimum thickness of the second capillary structure; and for the capillary structure, a thicker capillary structure can reduce the resistance of the working medium flow, and a thinner capillary structure can reduce the evaporation thermal resistance. Therefore, by arranging the thinner first capillary structure in the evaporation area, the evaporation effect of the working medium after absorbing heat is improved, and at the same time, by adopting the thicker second capillary structure, the resistance of the working medium during reflow is reduced. Thereby, the heat transfer effect of the working medium is improved, and then the heat dissipation effect of the chip is improved.

CN108801015A provides a temperature evaporating plate, wherein the plate body comprises a first cover plate and a second cover plate which are relatively covered, wherein the first cover plate and the second cover plate are hollow to form a first chamber, wherein the second cover plate comprises a protrusion protruding toward the outside of the plate body. Capillary structures are distributed on the inner surface of the plate body, and the capillary structures comprise a plurality of capillaries, wherein the capillaries on the inner surface of the protrusion of the second cover plate close to the heat source can be formed by using metal powder having a larger particle size than the capillaries on other inner surfaces, and the thickness of the powder can also be thicker. In this way, the heat transfer effect of the temperature evaporating plate can be optimized.

However, the traditional vapor chamber has poor heat dissipation effect, which makes it impossible to dissipate heat from the heating components of the electronic device in time when the electronic device is working, causing the electronic device to generate excessive heat.

### SUMMARY

The main purpose of the embodiments of the present application is to provide a vapor chamber, a radiator and an electronic device, and to provide a vapor chamber that can effectively conduct and dissipate heat to a heating element.

In a first aspect, an embodiment of the present application provides a vapor chamber, including:
a bottom plate including a first heat dissipation area and a second heat dissipation area provided at a peripheral side of the first heat dissipation area, where the first heat dissipation area is configured to correspond to a heating element;
a top plate spaced apart from the bottom plate;
a side plate, where the side plate is configured to surround a peripheral side of the second heat dissipation area of the bottom plate and connect the bottom plate and the top plate, and the bottom plate, the top plate and the side plate are enclosed to form an evaporation cavity for accommodating a fluid medium; and
a backflow piece provided in the evaporation cavity, where the backflow piece is configured to connect the bottom plate and the top plate;
the first heat dissipation area is provided with at least a first capillary structure layer on a side close to the top plate, the second heat dissipation area is provided with at least a second capillary structure layer on a side close to the top plate, the first capillary structure layer has a capillary force greater than a capillary force of the second capillary structure layer, and a flow resistance of the fluid medium in the second capillary structure layer is smaller than a flow resistance of the fluid medium in the first capillary structure layer. The first capillary structure layer comprises a capillary structure formed by sintering at least one of metal powder and diamond powder; the second capillary structure layer comprises at least one of a copper mesh structure layer, a trench structure layer, a thermally conductive fiber layer, and a nanofiber layer. The first heat dissipation area comprises a core area and a connection area, the core area is configured to correspond to the heating element, and the connection area is provided at a peripheral side of the core area and is connected to the second heat dissipation area. The first capillary structure layer is configured to cover at least a part of the core area, a distance between the core area and the top plate is a first distance, a distance between the second heat dissipation area and the top plate is a second distance, and the first distance is greater than the second distance. Both the first capillary structure layer and the second capillary structure layer are configured to cover the connection area, and in response to that both the first capillary structure layer and the second capillary structure layer cover the connection area, the second capillary structure layer is provided on a surface of the connection area, and the first capillary structure layer partially covers the second capillary structure layer.

In a second aspect, an embodiment of the present application provides a radiator, including a heat dissipation structure and the vapor chamber as described above, and the heat dissipation structure is connected to the vapor chamber.

In a third aspect, an embodiment of the present application provides an electronic device, including the radiator as described above.

The present application provides a vapor chamber, a radiator and an electronic device. The vapor chamber includes: a bottom plate, a top plate, a side plate and a backflow piece. The bottom plate includes a first heat dissipation area and a second heat dissipation area provided at a peripheral side of the first heat dissipation area. The first heat dissipation area is provided corresponding to the heating element. The top plate is spaced apart from the bottom plate. The side plate surrounds the peripheral side of the second heat dissipation area and connects the bottom plate and the top plate. The bottom plate, the top plate and the side plate are enclosed to form an evaporation cavity for accommodating a fluid medium. The backflow piece is provided in the evaporation cavity and connects the bottom plate and the top plate. The first heat dissipation area is provided with at least a first capillary structure layer on the side near the top plate, and the second heat dissipation area is provided with at least a second capillary structure layer on the side near the top plate. The capillary force of the first capillary structure layer is greater than that of the second capillary structure layer, and the flow resistance of the fluid medium in the second capillary structure layer is smaller than that in the first capillary structure layer. In the embodiment of the present application, two different capillary structures are provided on the bottom plate, the first capillary structure layer can improve the capillary force and heat conduction efficiency, and the second capillary structure layer can reduce the backflow resistance of the condensed liquid, therefore, the transmission efficiency of the vapor chamber is improved, and the heat dissipation problem of the vapor chamber in high power consumption and high heat flow density chip application scenarios is solved.

### BRIEF DESCRIPTION OF THE DRAWINGS

In order to illustrate the technical solutions of the embodiments of the present application more clearly, accompanying drawings needed to be used in the description of the embodiments will be briefly described below. Obviously, the accompanying drawings in the following description are some embodiments of the present application. For those skilled in the art, other drawings can also be obtained based on these drawings without creative efforts.
FIG. 1 is a schematic structural diagram of a vapor chamber according to an embodiment of the present application.
FIG. 2A and FIG. 2B are schematic diagrams of a second capillary structure layer provided in the vapor chamber according to an embodiment of the present application.
FIG. 3A is a top structural diagram of a bottom plate of the vapor chamber according to an embodiment of the present application.
FIG. 3B to FIG. 3E are schematic cross-sectional structural diagrams of a groove in the trench capillary structure when the capillary structure in the vapor chamber according to an embodiment of the present application is a trench capillary structure.
FIG. 4 is a schematic structural diagram of a modification of the vapor chamber according to an embodiment of the present application.
FIG. 5 is a schematic structural diagram of another modification of the vapor chamber according to an embodiment of the present application.
FIG. 6 is a schematic structural diagram of a radiator according to an embodiment of the present application.
FIG. 7 is a schematic structural block diagram of an electronic device according to an embodiment of the present application.

### DETAILED DESCRIPTION OF THE EMBODIMENTS

The technical solutions in the embodiments of the present application will be clearly and completely described below with reference to the accompanying drawings. Obviously, the described embodiments are some rather than all of the embodiments of the present application. Based on the embodiments in the present application, all other embodiments obtained by those skilled in the art without creative efforts fall within the scope of the present application.

The flowcharts shown in the accompanying drawings are only examples and do not necessarily include all contents and operations/steps, nor are they necessarily performed in the order described. For example, some operations/steps can also be decomposed, combined or partially merged, so the actual order of execution may change according to actual conditions.

It should be noted that the terms used in the embodiments of the present application are only for the purpose of describing specific embodiments and are not intended to limit the present application. As used in the embodiments and the appended claims, the singular forms "a", "the" and "this" are intended to include the plural forms as well, unless the context clearly dictates otherwise. It should be understood that the term "and/or" as used herein refers to and includes any or all possible combinations of one or more of the associated listed items.

At present, IC chips are the core of computing in electronic devices and one of the main heating components of electronic devices. With the development of 5G communication technology, communication products are pursuing large capacity and high performance. In particular, some multi-functional IC chips are becoming more and more integrated, causing the power consumption and heat flow density of IC chips to continue to rise, posing severe challenges to heat dissipation technology.

At present, liquid cooling technology is not yet mature, and chip heat dissipation problems mainly rely on air-cooling heat dissipation technology to solve, and vapor chamber heat dissipation technology is the key technology for air-cooling heat dissipation. A vapor chamber (VC) mainly includes a shell, a capillary structure and a working medium (also called a fluid medium). The VC forms a closed cavity. The inside of the cavity is evacuated and filled with the working medium, which causes the working medium to undergo phase change and transfer heat.

However, the traditional vapor chamber has poor heat dissipation effect, which makes it impossible to dissipate heat from the heating components of the electronic device in time when the electronic device is working, causing the electronic device to generate excessive heat.

Based on this, the present application provides a vapor chamber, a radiator and an electronic device, aiming to provide a vapor chamber that can effectively conduct and dissipate heat to a heating element, so that the heating element can be dissipated heat in a timely manner when the electronic device is working, thereby preventing the electronic device from overheating and causing malfunctions or accidents.

Some embodiments of the present application will be described in detail below with reference to the accompanying drawings. The following embodiments and features in the embodiments can be combined with each other if there is no conflict.

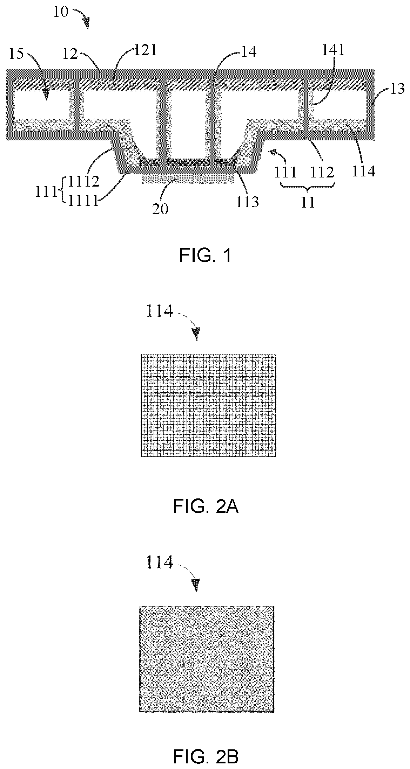

Please refer to FIG. 1, which is a schematic cross-sectional structural diagram of a vapor chamber according to an embodiment of the present application.

As shown in FIG. 1, the vapor chamber 10 is configured to adapt to a heating element 20 to dissipate heat from the heating element 20. The vapor chamber 10 includes a bottom plate 11, a top plate 12, a side plate 13 and a backflow piece 14. The bottom plate 11 includes a first heat dissipation area 111 and a second heat dissipation area 112 provided at a peripheral side of the first heat dissipation area 111. The first heat dissipation area 111 is provided corresponding to the heating element 20. The top plate 12 is spaced apart from the bottom plate 11, and the side plate 13 surrounds a peripheral side of the second heat dissipation area 112 of the bottom plate 11 and connects the bottom plate 11 and the top plate 12. The bottom plate 11, the top plate 12 and the side plates 13 are enclosed to form an evaporation cavity 15 for accommodating a fluid medium, and the fluid medium includes at least one of water, propanol, acetone, fluoride, ammonia or ethanol.

The first heat dissipation area 111 provided corresponding to the heating element 20 can be configured such that the first heat dissipation area 111 is attached to the heating element 20, or the first heat dissipation area 111 is connected to the heating element 20 through a connection medium. The connection medium includes, but is not limited to, adhesives such as thermally conductive silicone grease. Multiple backflow pieces 14 are provided, which are provided at intervals in the evaporation cavity 15, connect the bottom plate 11 and the top plate 12 to support the top plate 12, and provide a drainage path for the fluid medium to return from the top plate 12 to the bottom plate 11.

The first heat dissipation area 111 is provided with at least a first capillary structure layer 113 on a side close to the top plate 12, and the second heat dissipation area 112 is provided with at least a second capillary structure layer 114 on the side close to the top plate 12. The capillary force of the first capillary structure layer 113 is greater than the capillary force of the second capillary structure layer 114, and the flow resistance of the fluid medium in the second capillary structure layer 114 is smaller than the flow resistance in the first capillary structure layer 113. The heating element 20 includes, but is not limited to, an IC chip.

The fluid medium in the embodiment of the present application can also be other working media that can undergo phase changes, as long as the working medium can undergo corresponding physical state changes by absorbing heat and releasing heat.

In the embodiment of the present application, the bottom plate 11 and the side plate 13 can be integrally formed, for example, through stamping, molding, or casting. Alternatively, the bottom plate 11 and the side plate 13 can be formed separately and then fixedly connected by welding, which is not limited here.

In this embodiment, by providing the first capillary structure layer 113 in the first heat dissipation area 111 of the bottom plate 11 and the second capillary structure layer 114 in the second heat dissipation area 112 of the bottom plate 11, since the capillary structure has a pore structure and the pore structure will generate a strong capillary force, all the fluid medium injected into the evaporation cavity 15 is adsorbed in these pore structures. When the heating element 20 starts to work, the heating element 20 starts to generate heat, and heats the fluid medium in the pore structure of the first capillary structure layer 113 covered by the first heat dissipation area 111 above the heating element 20, so that the temperature of the fluid medium starts to rise.

When the temperature rises above the evaporation temperature of the fluid medium itself, the fluid medium changes from a liquid state to a vapor state. Because the vapor state fluid medium is not restricted by the structure, the fluid medium can fill the entire evaporation cavity 15. When the fluid medium in the pore structure of the first capillary structure layer 113 covered by the first heat dissipation area 111 above the heating element 20 is reduced, due to capillary action, the fluid medium in the pore structure of the second capillary structure layer 114 covered by the second heat dissipation area 112 outside the heating element 20 corresponding to the bottom plate 11 will be pulled into the first heat dissipation area 111 corresponding to the heating element 20, and the newly added fluid medium will continue to absorb the heat generated by the heating element 20, and continue to heat up and evaporate.

When the steam hits the top plate 12 of the vapor chamber 10, the external air or the external heat dissipation structure can take away part of the heat so that the temperature of the steam will drop rapidly. When the temperature drops below the condensation temperature of the fluid medium, the steam is condensed into liquid state. The fluid medium in the liquid state is returned to the bottom plate 11 of the vapor chamber 10 through the backflow piece 14, and in this cycle, the heat of the heating element 20 is continuously and efficiently transferred and dissipated into the air.

Based on the fact that the capillary force of the first capillary structure layer 113 is greater than the capillary force of the second capillary structure layer 114, the attractive force of the first heat dissipation area 111 located on the bottom plate 11 to the fluid medium is greater than that of the second heat dissipation area 112 to the fluid medium. Based on the fact that the flow resistance of the fluid medium in the first capillary structure layer 113 is greater than the flow resistance of the fluid medium in the second capillary structure layer 114, it is easier for the fluid medium to stay on the first heat dissipation area 111 and condense. The resulting fluid medium can more easily flow from the second heat dissipation area 112 to the first heat dissipation area 111, thereby improving the heat conduction efficiency of the first heat dissipation area 111 and realizing the heat dissipation of the heating element 20 by the vapor chamber 10.

At least one of the bottom plate 11, the top plate 12 or the side plate 13 of the vapor chamber 10 is provided with a liquid injecting opening communicated with the evaporation cavity 15. The evaporation cavity 15 can be evacuated through the liquid injecting opening, and a preset amount of fluid medium is added into the evaporation cavity 15 through the liquid injecting opening. After the fluid medium is injected, the liquid injecting opening is sealed. The liquid injecting opening can be sealed by a sealing member, or by electric welding, cold welding or ultrasonic welding, which is not limited here.

As shown in FIG. 1, the first heat dissipation area 111 includes a core area 1111 and a connection area 1112. The core area 1111 is provided corresponding to the heating element 20. For example, the core area 1111 is attached to the heating element 20, or the core area 1111 is connected to the heating element 20 through a connection medium. The connection area 1112 is provided around the core area 1111 and connected to the second heat dissipation area 112.

The first capillary structure layer 113 at least partially covers the core area 1111. A distance between the core area 1111 and the top plate 12 is a first distance, and the distance between the second heat dissipation area 112 and the top plate 12 is a second distance. The first distance is greater than the second distance.

The first capillary structure layer 113 and the second capillary structure layer 114 both cover the connection area 1112. The second capillary structure layer 114 is provided on a surface of the connection area 1112, and the first capillary structure layer 113 partially covers the second capillary structure layer 114. For example, the second capillary structure layer 114 is provided on the surface of the connection area 1112, and the first capillary structure layer 113 covers 10% to 90% of the area on the side of the second capillary structure layer 114 close to the core area 1111.

Since the flow resistance of the fluid medium in the first capillary structure layer 113 is greater than the flow resistance of the fluid medium in the second capillary structure layer 114, covering the connection area 1112 with the second capillary structure layer 114 facilitates the fluid medium, after condensation, to flow more easily from the second heat dissipation area 112 to the first heat dissipation area 111.

The first capillary structure layer 113 includes a capillary structure formed by sintering at least one of metal powder and diamond powder, and the metal powder includes, but is not limited to, at least one of copper powder, gold powder, and silver powder.

The second capillary structure layer 114 includes at least one of a copper mesh structure layer, a trench structure layer, a thermally conductive fiber layer, and a nanofiber layer. The second heat dissipation area 112 can be covered with the second capillary structure layer 114 through processes such as sintering, welding, and etching.

Referring to FIG. 2A and FIG. 2B, for example, when the second capillary structure layer 114 is a copper mesh structure layer, copper wires in the copper mesh structure can be arranged in a staggered array of multiple copper wires. For example, multiple copper wires are staggered in an orthogonal array, as shown in FIG. 2A, or multiple copper wires are arranged in a diagonal and staggered array at an angle, as shown in FIG. 2B.

In an embodiment, the copper mesh of the copper mesh structure layer can be a single layer of copper mesh, or a multi-layer copper mesh stacked at different angles, which is not limited here.

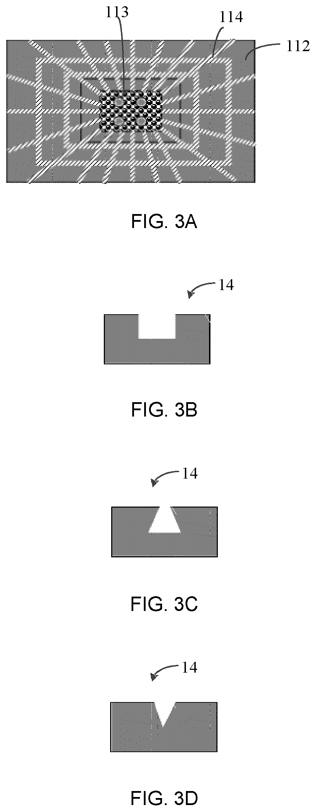

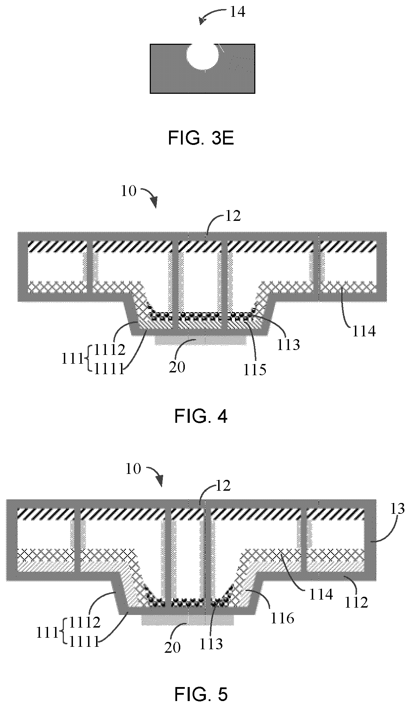

Referring to FIG. 3A, for example, the case where the second capillary structure layer 114 is a trench structure layer is described as an example. A trench structure is provided on the side of the second heat dissipation area 112 close to the top plate 12. The trench structure includes a first groove radiating outward with the first heat dissipation area 111 as a center and a second groove connecting two adjacent first grooves. By communicating the first groove with the second groove, it can effectively help the condensed liquid to flow back to the first heat dissipation area 111. The shapes of the first groove and the second groove can be any one of polygonal, arc-shaped, circular or special-shaped structures, or at least a combination of the two, which is not limited here.

As shown in FIG. 3B to FIG. 3E, the shape of any one of the first groove and/or the second groove is a triangle, a rectangle, a trapezoid, or an arc.

Please refer to FIG. 4, in some embodiments, the core area 1111 is also covered with a third capillary structure layer 115. The third capillary structure layer 115 is provided on the surface of the core area 1111, and the first capillary structure layer is provided on the side of the third capillary structure layer 115 close to the top plate 12. The flow resistance of the fluid medium in the third capillary structure layer 115 is smaller than the flow resistance of the fluid medium in the first capillary structure layer 113.

In an embodiment, the third capillary structure layer 115 includes at least one of a copper mesh structure layer, a thermally conductive fiber layer, a nanofiber layer, and a trench structure layer.

Since the flow resistance of the fluid medium in the third capillary structure layer 115 is smaller than the flow resistance of the fluid medium in the first capillary structure layer 113, covering the core area 1111 with the third capillary structure layer 115 facilitates the fluid medium, after condensation, to flow more easily from the second heat dissipation area 112 to the first heat dissipation area 111.

Please refer to FIG. 5, in some embodiments, the second heat dissipation area 112 and the connection area 1112 are also provided with a fourth capillary structure layer 116, and the fourth capillary structure layer 116 is provided on the surfaces of the second heat dissipation area 112 and the connection area 1112. The second capillary structure layer 114 is provided on the surface of the fourth capillary structure layer 116. The flow resistance of the fluid medium in the fourth capillary structure layer 116 is smaller than the flow resistance of the fluid medium in the second capillary structure layer 114.

Since the flow resistance of the fluid medium in the fourth capillary structure layer 116 is smaller than the flow resistance in the second capillary structure layer 114, covering the second heat dissipation area 112 and the connection area 1112 with the fourth capillary structure layer 116 facilitates the fluid medium, after condensation, to flow more easily from the second heat dissipation area 112 to the first heat dissipation area 111.

In an embodiment, the fourth capillary structure layer 116 includes at least one of a copper mesh structure layer, a thermally conductive fiber layer, a nanofiber layer, and a groove structure layer.

In an embodiment, the fourth capillary structure layer 116 is a trench structure layer, and the second capillary structure layer 114 is a copper mesh structure layer.

As shown in FIG. 1, in some embodiments, a fifth capillary structure layer 121 is provided on the side of the top plate 12 close to the bottom plate 11, and/or a sixth capillary structure layer 141 is provided on the surface of the backflow piece 14.

In an embodiment, the flow resistance of the fluid medium in the fifth capillary structure layer 121 and the sixth capillary structure layer 141 is smaller than the flow resistance in the first capillary structure layer 113.

For example, the fifth capillary structure layer 121 includes at least one of a copper mesh structure layer, a trench structure layer, a thermally conductive fiber layer, a nanofiber layer, and a capillary structure formed by powder sintering. The sixth capillary structure layer 141 includes at least one of a copper mesh structure layer, a trench structure layer, a thermally conductive fiber layer, a nanofiber layer, and a capillary structure formed by powder sintering.

For example, the case where the capillary structure layer is provided on the surfaces of the top plate 12 and the backflow piece 14 is described as an example.

Based on the fact that capillary structure layers are provided on the surfaces of the top plate 12 and the backflow piece 14, when the steam hits the top plate 12 of the vapor chamber 10 and is condensed into a liquid state, the capillary structure layer provided on the bottom plate 11 will pull the liquid state fluid medium adhered to the surface of the top plate 12 and the backflow piece 14 back to the bottom plate 11 of the vapor chamber 10 through the capillary force. That is, the capillary structure layer is provided on the surfaces of the backflow piece 14 and the top plate 12, which is beneficial for the condensed fluid medium to return to the bottom plate 11.

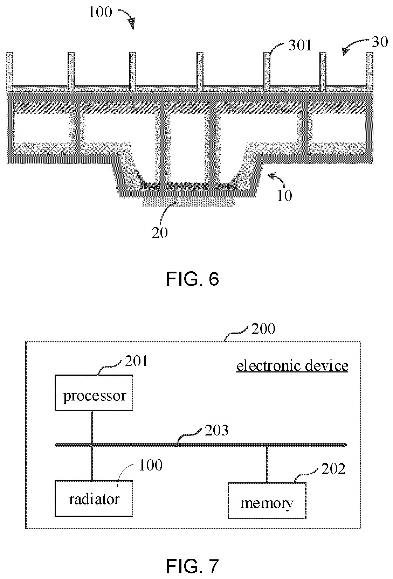

In some embodiments, an inner surface of the side plate 13 is also provided with a seventh capillary structure layer. The seventh capillary structure layer includes any one of a copper mesh structure layer, a groove structure layer, a thermally conductive fiber layer, a nanofiber layer, and a capillary structure formed by powder sintering. Please refer to FIG. 6, the present application also provides a radiator 100 for dissipating heat from the heating element 20. The radiator 100 includes a heat dissipation structure 30 and a vapor chamber 10 connected to the heat dissipation structure 30. The structure of the vapor chamber 10 can refer to any of the previous embodiments, and will not be described again here.

In an embodiment, the heat dissipation structure 30 is connected to the top plate 12 of the vapor chamber 10 for dissipating heat from the vapor chamber 10. For example, the heat dissipation structure 30 is provided with a plurality of spaced heat dissipation fins 301. The spaced arrangement of the heat dissipation fins 301 can increase the contact area between the heat dissipation structure 30 and the air, thereby facilitating heat dissipation of the vapor chamber 10.

Referring to FIG. 7, the present application also provides an electronic device 200. The electronic device 200 includes a processor 201, a memory 202 and a radiator 100. The processor 201 and the memory 202 are connected through a bus 203. The bus is, for example, inter-integrated circuit (I2C) bus, and the radiator 100 is configured to dissipate heat from the processor 201.

In an embodiment, the processor 201 is configured to provide computing and control capabilities to support the operation of the entire electronic device 200. The processor 201 can be a central processing unit (CPU). The processor 201 can also be other general-purpose processors, digital signal processors (DSP), application specific integrated circuits (ASIC), field-programmable gate array (FPGA) or other programmable logic devices, discrete gate or transistor logic devices, discrete hardware components, etc. The general processor can be a microprocessor or the processor can be any conventional processor.

In an embodiment, the memory 202 can be a Flash chip, a read-only memory (ROM) disk, an optical disk, a USB disk, a mobile hard disk, or the like.

The electronic device 200 includes, but is not limited to, a base station, a mobile phone, a tablet computer, a notebook computer, a desktop computer, a personal digital assistant, a wearable device, etc.

It should be understood that the term "and/or" as used in this specification and the appended claims refers to and includes any and all possible combinations of one or more of the associated listed items. It should be noted that, as used herein, the terms "include", "comprise" or any other variation thereof are intended to cover a non-exclusive inclusion, such that a process, method, article or system that includes a list of elements not only includes those elements, but also includes other elements not expressly listed or that are inherent to the process, method, article or system. Without further limitation, an element defined by the statement "include a..." does not exclude the presence of other identical elements in the process, method, article, or system that includes that element.

In the above embodiments, each embodiment is described with its own emphasis. For parts that are not described in detail in a certain embodiment, please refer to the relevant descriptions of other embodiments.

## Claims

1. A vapor chamber (10), **characterized by** comprising:
a bottom plate (11) comprising a first heat dissipation area (111) and a second heat dissipation area (112) provided at a peripheral side of the first heat dissipation area (111), wherein the first heat dissipation area (111) is configured to correspond to a heating element (20);
a top plate (12) spaced apart from the bottom plate (11);
a side plate (13), wherein the side plate (13) is configured to surround a peripheral side of the second heat dissipation area (112) of the bottom plate (11) and connect the bottom plate (11) and the top plate (12), and the bottom plate (11), the top plate (12) and the side plate (13) are enclosed to form an evaporation cavity (15) for accommodating a fluid medium; and
a backflow piece (14) provided in the evaporation cavity (15), wherein the backflow piece (14) is configured to connect the bottom plate (11) and the top plate (12);
wherein the first heat dissipation area (111) is provided with at least a first capillary structure layer (113) on a side close to the top plate (12), the second heat dissipation area (112) is provided with at least a second capillary structure layer (114) on a side close to the top plate (12), the first capillary structure layer (113) has a capillary force greater than a capillary force of the second capillary structure layer (114), and a flow resistance of the fluid medium in the second capillary structure layer (114) is smaller than a flow resistance of the fluid medium in the first capillary structure layer (113);
wherein the first capillary structure layer (113) comprises a capillary structure formed by sintering at least one of metal powder and diamond powder; the second capillary structure layer (114) comprises at least one of a copper mesh structure layer, a trench structure layer, a thermally conductive fiber layer, and a nanofiber layer;
wherein the first heat dissipation area (111) comprises a core area (1111) and a connection area (1112), the core area (1111) is configured to correspond to the heating element (20), and the connection area (1112) is provided at a peripheral side of the core area (1111) and is connected to the second heat dissipation area (112);
wherein the first capillary structure layer (113) is configured to cover at least a part of the core area (1111), a distance between the core area (1111) and the top plate (12) is a first distance, a distance between the second heat dissipation area (112) and the top plate (12) is a second distance, and the first distance is greater than the second distance; and
wherein both the first capillary structure layer (113) and the second capillary structure layer (114) are configured to cover the connection area (1112), and in response to that both the first capillary structure layer (113) and the second capillary structure layer (114) cover the connection area (1112), the second capillary structure layer (114) is provided on a surface of the connection area (1112), and the first capillary structure layer (113) partially covers the second capillary structure layer (114).

2. The vapor chamber (10) according to claim 1, wherein the core area (1111) is also covered with a third capillary structure layer (115), the third capillary structure layer (115) is provided on a surface of the core area (1111), and the first capillary structure layer (113) is provided on a side of the third capillary structure layer (115) close to the top plate (12); and
wherein a flow resistance of the fluid medium in the third capillary structure layer (115) is smaller than the flow resistance of the fluid medium in the first capillary structure layer (113).

3. The vapor chamber (10) according to claim 2, wherein the third capillary structure layer (115) comprises at least one of a copper mesh structure layer, a trench structure layer, a thermally conductive fiber layer, and a nanofiber layer.

4. The vapor chamber (10) according to claim 1, wherein the second heat dissipation area (112) and the connection area (1112) are further provided with a fourth capillary structure layer (116), and the fourth capillary structure layer (116) is provided on surfaces of the second heat dissipation area (112) and the connection area (1112), and the second capillary structure layer (114) is provided on a surface of the fourth capillary structure layer (116); and
wherein a flow resistance of the fluid medium in the fourth capillary structure layer (116) is smaller than the flow resistance of the fluid medium in the second capillary structure layer (114).

5. The vapor chamber (10) according to any one of claims 1 to 4, wherein a fifth capillary structure layer (121) is provided on a side of the top plate (12) close to the bottom plate (11); and/or a sixth capillary structure layer (141) is provided on a surface of the backflow piece (14).

6. The vapor chamber (10) according to any one of claims 1 to 4, wherein the fluid medium comprises at least one of water, propanol, acetone, fluoride, ammonia liquid or ethanol.

7. A radiator (100), **characterized by** comprising a heat dissipation structure (30) and the vapor chamber (10) according to any one of claims 1 to 6, wherein the heat dissipation structure (30) is connected to the vapor chamber (10).

8. An electronic device (200), **characterized by** comprising the radiator (100) according to claim 7.

## Patentansprüche

1. Dampfkammer (10), **dadurch gekennzeichnet, dass** sie Folgendes umfasst:
eine Bodenplatte (11), die einen ersten Wärmeableitungsbereich (111) und einen zweiten Wärmeableitungsbereich (112) umfasst, der an einer Umfangsseite des ersten Wärmeableitungsbereichs (111) angeordnet ist, wobei der erste Wärmeableitungsbereich (111) so ausgebildet ist, dass er einem Heizelement (20) zugeordnet ist;
eine Deckplatte (12), die von der Bodenplatte (11) beabstandet angeordnet ist;
eine Seitenplatte (13), wobei die Seitenplatte (13) dazu ausgebildet ist, eine Umfangsseite des zweiten Wärmeableitungsbereichs (112) der Bodenplatte (11) zu umgeben und die Bodenplatte (11) mit der Deckplatte (12) zu verbinden, und wobei die Bodenplatte (11), die Deckplatte (12) und die Seitenplatte (13) einen Verdampfungshohlraum (15) zur Aufnahme eines fluiden Mediums umschließen; und
ein Rückflusselement (14), das in dem Verdampfungshohlraum (15) angeordnet ist, wobei das Rückflusselement (14) dazu ausgebildet ist, die Bodenplatte (11) mit der Deckplatte (12) zu verbinden;
wobei der erste Wärmeableitungsbereich (111) auf einer nahe der Deckplatte (12) liegenden Seite mit mindestens einer ersten Kapillarstrukturschicht (113) versehen ist, der zweite Wärmeableitungsbereich (112) auf einer nahe der Deckplatte (12) liegenden Seite mit mindestens einer zweiten Kapillarstrukturschicht (114) versehen ist, die erste Kapillarstrukturschicht (113) eine größere Kapillarkraft als die zweite Kapillarstrukturschicht (114) aufweist und ein Strömungswiderstand des fluiden Mediums in der zweiten Kapillarstrukturschicht (114) geringer ist als ein Strömungswiderstand des fluiden Mediums in der ersten Kapillarstrukturschicht (113);
wobei die erste Kapillarstrukturschicht (113) eine durch Sintern von Metallpulver und/oder Diamantpulver gebildete Kapillarstruktur umfasst und die zweite Kapillarstrukturschicht (114) mindestens eine der folgenden Schichten umfasst: eine Kupfernetzstrukturschicht, eine Nutstrukturschicht, eine wärmeleitende Faserschicht oder eine Nanofaserschicht;
wobei der erste Wärmeableitungsbereich (111) einen Kernbereich (1111) und einen Verbindungsbereich (1112) umfasst, der Kernbereich (1111) so ausgebildet ist, dass er dem Heizelement (20) zugeordnet ist**,** und der Verbindungsbereich (1112) an einer Umfangsseite des Kernbereichs (1111) angeordnet und mit dem zweiten Wärmeableitungsbereich (112) verbunden ist;
wobei die erste Kapillarstrukturschicht (113) dazu ausgebildet ist, mindestens einen Teil des Kernbereichs (1111) zu bedecken, ein Abstand zwischen dem Kernbereich (1111) und der Deckplatte (12) ein erster Abstand ist, ein Abstand zwischen dem zweiten Wärmeableitungsbereich (112) und der Deckplatte (12) ein zweiter Abstand ist und der erste Abstand größer als der zweite Abstand ist; und
wobei sowohl die erste Kapillarstrukturschicht (113) als auch die zweite Kapillarstrukturschicht (114) dazu ausgebildet sind, den Verbindungsbereich (1112) zu bedecken, und wobei für den Fall, dass sowohl die erste Kapillarstrukturschicht (113) als auch die zweite Kapillarstrukturschicht (114) den Verbindungsbereich (1112) bedecken, die zweite Kapillarstrukturschicht (114) auf einer Oberfläche des Verbindungsbereichs (1112) angeordnet ist und die erste Kapillarstrukturschicht (113) die zweite Kapillarstrukturschicht (114) teilweise bedeckt.

2. Dampfkammer (10) nach Anspruch 1, wobei der Kernbereich (1111) ferner mit einer dritten Kapillarstrukturschicht (115) bedeckt ist, die dritte Kapillarstrukturschicht (115) auf einer Oberfläche des Kernbereichs (1111) angeordnet ist und die erste Kapillarstrukturschicht (113) auf einer nahe der Deckplatte (12) liegenden Seite der dritten Kapillarstrukturschicht (115) angeordnet ist; und
wobei ein Strömungswiderstand des fluiden Mediums in der dritten Kapillarstrukturschicht (115) geringer ist als der Strömungswiderstand des fluiden Mediums in der ersten Kapillarstrukturschicht (113).

3. Dampfkammer (10) nach Anspruch 2, wobei die dritte Kapillarstrukturschicht (115) mindestens eine der folgenden Schichten umfasst: eine Kupfernetzstrukturschicht, eine Nutstrukturschicht, eine wärmeleitende Faserschicht oder eine Nanofaserschicht.

4. Dampfkammer (10) nach Anspruch 1, wobei der zweite Wärmeableitungsbereich (112) und der Verbindungsbereich (1112) ferner mit einer vierten Kapillarstrukturschicht (116) versehen sind, die vierte Kapillarstrukturschicht (116) auf Oberflächen des zweiten Wärmeableitungsbereichs (112) und des Verbindungsbereichs (1112) angeordnet ist und die zweite Kapillarstrukturschicht (114) auf einer Oberfläche der vierten Kapillarstrukturschicht (116) angeordnet ist; und
wobei ein Strömungswiderstand des fluiden Mediums in der vierten Kapillarstrukturschicht (116) geringer ist als der Strömungswiderstand des fluiden Mediums in der zweiten Kapillarstrukturschicht (114).

5. Dampfkammer (10) nach einem der Ansprüche 1 bis 4, wobei auf einer nahe der Bodenplatte (11) liegenden Seite der Deckplatte (12) eine fünfte Kapillarstrukturschicht (121) angeordnet ist und/oder auf einer Oberfläche des Rückflusselements (14) eine sechste Kapillarstrukturschicht (141) angeordnet ist.

6. Dampfkammer (10) nach einem der Ansprüche 1 bis 4, wobei das fluide Medium mindestens eines der folgenden Medien umfasst: Wasser, Propanol, Aceton, Fluorid, flüssiges Ammoniak oder Ethanol.

7. Kühlkörper (100), **dadurch gekennzeichnet, dass** er eine Wärmeableitungsstruktur (30) und die Dampfkammer (10) nach einem der Ansprüche 1 bis 6 umfasst, wobei die Wärmeableitungsstruktur (30) mit der Dampfkammer (10) verbunden ist.

8. Elektronische Vorrichtung (200), **dadurch gekennzeichnet, dass** sie den Kühlkörper (100) nach Anspruch 7 umfasst.

## Revendications

1. Chambre à vapeur (10), **caractérisée en ce qu'**elle comprend :
une plaque inférieure (11) comprenant une première zone de dissipation de chaleur (111) et une deuxième zone de dissipation de chaleur (112) prévue sur un côté périphérique de la première zone de dissipation de chaleur (111), la première zone de dissipation de chaleur (111) étant configurée pour correspondre à un élément chauffant (20) ;
une plaque supérieure (12) espacée de la plaque inférieure (11) ;
une plaque latérale (13), la plaque latérale (13) étant configurée pour entourer un côté périphérique de la deuxième zone de dissipation de chaleur (112) de la plaque inférieure (11) et relier la plaque inférieure (11) et la plaque supérieure (12), et la plaque inférieure (11), la plaque supérieure (12) et la plaque latérale (13) se fermant pour former une cavité d'évaporation (15) destinée à accueillir un milieu fluide ; et
une pièce de reflux (14) prévue dans la cavité d'évaporation (15), la pièce de reflux (14) étant configurée pour relier la plaque inférieure (11) et la plaque supérieure (12) ;
dans laquelle la première zone de dissipation de chaleur (111) est pourvue d'au moins une première couche à structure capillaire (113) sur un côté proche de la plaque supérieure (12), la deuxième zone de dissipation de chaleur (112) est pourvue d'au moins une deuxième couche à structure capillaire (114) sur un côté proche de la plaque supérieure (12), la première couche à structure capillaire (113) produit une force capillaire supérieure à une force capillaire de la deuxième couche à structure capillaire (114), et une résistance à l'écoulement du milieu fluide dans la deuxième couche à structure capillaire (114) est inférieure à une résistance à l'écoulement du milieu fluide dans la première couche à structure capillaire (113) ;
dans laquelle la première couche à structure capillaire (113) comprend une structure capillaire formée en frittant au moins l'une d'une poudre de métal et d'une poudre de diamant ; la deuxième couche à structure capillaire (114) comprend au moins l'une parmi une couche à structure à mailles de cuivre, une couche à structure en tranchée, une couche de fibres thermoconductrices et une couche de nanofibres ;
dans laquelle la première zone de dissipation de chaleur (111) comprend une zone centrale (1111) et une zone de liaison (1112), la zone centrale (1111) étant configurée pour correspondre à l'élément chauffant (20), et la zone de liaison (1112) étant prévue sur un côté périphérique de la zone centrale (1111) et étant reliée à la deuxième zone de dissipation de chaleur (112) ;
dans laquelle la première couche à structure capillaire (113) est configurée pour recouvrir au moins une partie de la zone centrale (1111), une distance entre la zone centrale (1111) et la plaque supérieure (12) est une première distance, une distance entre la deuxième zone de dissipation de chaleur (112) et la plaque supérieure (12) est une deuxième distance, et la première distance est supérieure à la deuxième distance ; et
dans laquelle la première couche à structure capillaire (113) et la deuxième couche à structure capillaire (114) sont toutes deux configurées pour recouvrir la zone de liaison (1112), et en réponse à ce que la première couche à structure capillaire (113) et la deuxième couche à structure capillaire (114) recouvrent toutes deux la zone de liaison (1112), la deuxième couche à structure capillaire (114) est prévue sur une surface de la zone de liaison (1112), et la première couche à structure capillaire (113) recouvre en partie la deuxième couche à structure capillaire (114).

2. Chambre à vapeur (10) selon la revendication 1, dans laquelle la zone centrale (1111) est également recouverte d'une troisième couche à structure capillaire (115), la troisième couche à structure capillaire (115) est prévue sur une surface de la zone centrale (1111), et la première couche à structure capillaire (113) est prévue sur un côté de la troisième couche à structure capillaire (115) proche de la plaque supérieure (12) ; et
dans laquelle une résistance à l'écoulement du milieu fluide dans la troisième couche à structure capillaire (115) est inférieure à la résistance à l'écoulement du milieu fluide dans la première couche à structure capillaire (113).

3. Chambre à vapeur (10) selon la revendication 2, dans laquelle la troisième couche à structure capillaire (115) comprend au moins l'une parmi une couche à structure à mailles de cuivre, une couche à structure en tranchée, une couche de fibres thermoconductrices et une couche de nanofibres.

4. Chambre à vapeur (10) selon la revendication 1, dans laquelle la deuxième zone de dissipation de chaleur (112) et la zone de liaison (1112) sont en outre pourvues d'une quatrième couche à structure capillaire (116), et la quatrième couche à structure capillaire (116) est prévue sur des surfaces de la deuxième zone de dissipation de chaleur (112) et de la zone de liaison (1112), et la deuxième couche à structure capillaire (114) est prévue sur une surface de la quatrième couche à structure capillaire (116) ; et dans laquelle une résistance à l'écoulement du milieu fluide dans la quatrième couche à structure capillaire (116) est inférieure à la résistance à l'écoulement du milieu fluide dans la deuxième couche à structure capillaire (114).

5. Chambre à vapeur (10) selon l'une quelconque des revendications 1 à 4, dans laquelle une cinquième couche à structure capillaire (121) est prévue sur un côté de la plaque supérieure (12) proche de la plaque inférieure (11) ; et/ou une sixième couche à structure capillaire (141) est prévue sur une surface de la pièce de reflux (14).

6. Chambre à vapeur (10) selon l'une quelconque des revendications 1 à 4, dans laquelle le milieu fluide comprend au moins l'un parmi l'eau, le propanol, l'acétone, le fluorure, l'ammoniaque ou l'éthanol.

7. Radiateur (100), **caractérisé en ce qu'**il comprend une structure de dissipation de chaleur (30) et la chambre à vapeur (10) selon l'une quelconque des revendications 1 à 6, dans lequel la structure de dissipation de chaleur (30) est reliée à la chambre à vapeur (10).

8. Dispositif électronique (200), **caractérisé en ce qu'**il comprend le radiateur (100) selon la revendication 7.
